(19)

Europäisches
Patentamt
European
Patent Office
Office européen
des brevets

(11)  **EP 3 355 372 B1**

(12)  **EUROPEAN PATENT SPECIFICATION**

(45) Date of publication and mention
of the grant of the patent:
**28.10.2020  Bulletin 2020/44**

(21) Application number: **16848582.9**

(22) Date of filing: **20.09.2016**

(51) Int Cl.:
*H01L 33/64* ^(2010.01)      *H01S 5/024* ^(2006.01)
*B23K 1/00* ^(2006.01)      *B23K 35/30* ^(2006.01)
*C22C 5/02* ^(2006.01)      *H01L 23/36* ^(2006.01)
*H01L 23/40* ^(2006.01)      *B23K 101/42* ^(2006.01)
*B23K 103/10* ^(2006.01)      *B23K 103/12* ^(2006.01)

(86) International application number:
**PCT/JP2016/077657**

(87) International publication number:
**WO 2017/051794 (30.03.2017 Gazette 2017/13)**

(54) **LIGHT-EMISSION MODULE HAVING COOLER AND PRODUCTION METHOD FOR LIGHT-EMISSION MODULE HAVING COOLER**

LICHTEMISSIONSMODUL MIT KÜHLER UND HERSTELLUNGSVERFAHREN FÜR EIN LICHTEMISSIONSMODUL MIT KÜHLER

MODULE LUMINESCENT AVEC REFROIDISSEUR, ET PROCÉDÉ DE FABRICATION DE CELUI-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **25.09.2015   JP 2015188346**

(43) Date of publication of application:
**01.08.2018   Bulletin 2018/31**

(73) Proprietor: **Mitsubishi Materials Corporation
Chiyoda-ku
Tokyo 100-8117 (JP)**

(72) Inventors:
• **NAGASE Toshiyuki
Kitamoto-shi
Saitama 364-0022 (JP)**

• **KOMASAKI Masahito
Kitamoto-shi
Saitama 364-0022 (JP)**
• **IWAZAKI Wataru
Kitamoto-shi
Saitama 364-0022 (JP)**

(74) Representative: **Hoffmann Eitle
Patent- und Rechtsanwälte PartmbB
Arabellastraße 30
81925 München (DE)**

(56) References cited:
EP-A1- 2 455 991      EP-A1- 2 833 400
WO-A1-2008/126564      WO-A1-2014/148420
JP-A- 2007 087 983      JP-A- 2008 277 654
JP-A- 2013 229 561      JP-A- 2014 013 924
JP-A- 2014 026 769      JP-A- 2014 054 653
JP-A- 2014 112 696      JP-A- 2015 166 304

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to a light-emitting module with a cooler having excellent heat resisting properties, and a method of producing a light-emitting module with a cooler.

BACKGROUND ART

Light-emitting diode (LED) elements are widely used in various types of light sources by virtue of their long service life and stable light-emitting characteristics. The photo-transformation efficiency of such LED elements ranges from approximately 20% to 30%, and the remaining 70% to 80% of energy directly becomes heat in the LED elements. Meanwhile, LED elements are devices vulnerable to heat, and the guaranteed temperature for a general operation ranges from approximately -10°C to 85°C. Therefore, an LED module substrate for mounting an LED element is provided with a heat sink for efficiently diffusing heat generated in the LED element, a cooler for performing heat exchange, or the like. The same applies to not only LEDs but also to light-emitting elements.

In the related art, in LED modules (light-emitting element modules), an insulating layer which is a substrate having insulating properties and a heat sink are bonded to each other using a Au-Sn alloy solder by virtue of high thermal conductivity, easiness of bonding, and the like. For example, in a case where AlN is used as an insulating layer and Cu having excellent thermal conductivity is used as a heat sink, a Cu thin-plate is formed in an AlN insulating layer, and the Cu thin-plate and the heat sink are bonded to each other using a Au-Sn alloy solder (for example, refer to Patent Documents 1 to 3).

EP 2833400 A1 relates to a power module substrate with a heat sink including a power module substrate having a circuit layer disposed on one surface of an insulating layer, and a heatsink bonded to the other surface of this power module substrate, wherein the bonding surface of the heat sink and the bonding surface of the power module substrate are each composed of aluminium or an aluminium alloy, the circuit layer is made of copper and has a thickness of 0.6 mm, a bonding layer having a Mg-containing compound which contains Mg dispersed in an Al-Si eutectic composition is formed at the bonding interface between the heat sink and the power module substrate, and the thickness t of this bonding layer is within a range from 5 pm to 80 pm.

WO 2014148420 A1 relates to a method for manufacturing a power module substrate having following steps: a first lamination step in which a copper sheet is laminated to one side of a ceramic substrate with an active-metal material and a filler material interposed therebetween, the melting point of said filler material being less than or equal to 660°C; a second lamination step in which an aluminium sheet is laminated to the other side of the ceramic substrate with a bonding material interposed therebetween; and a heat-treatment step in which the laminated ceramic substrate, copper sheet, and aluminium sheet are heat-treated. The copper sheet and the aluminium sheet are bonded to the ceramic substrate simultaneously, the copper sheet has a thickness of 0.1 mm to 1.0 mm, and the aluminium sheet has a thickness of 0.1 mm to 3.0 mm.

EP 2455991 A1 relates to a LED package with heat radiating properties, manufacturing method of the LED package, and an LED chip assembly used in the LED package. The LED package is characterized in that the LED chip assembly is bonded to a circuit board created by forming a circuit layer on a metal substrate with an insulation layer therebetween, whereas an LED chip of the LED chip assembly and the circuit layer of the circuit board are connected via an electrical connection member, the circuit layer has a thickness of 0.005 mm to 0.4 mm, the ratio of an area of the LED chip to an area of the insulation layer is 1:25 or 1:100, and at least the LED chip assembly and the electrical connection member are encapsulated with resin encapsulant including fluorescent material.

JP 2015-166304 A discloses a power module comprising, a circuit layer formed on one surface side of an insulating layer and on which a semiconductor element is mounted, a metal layer and a cooler laminated in order on the other surface side of the insulating layer, wherein the circuit layer is formed of copper having a thickness of 0.1 mm to 1.0 mm, and wherein the metal layer and the cooler are formed of aluminium and directly bonded to each other.

CITATION LIST

PATENT LITERATURE

[Patent Document 1] Japanese Unexamined Patent Application, First Publication No. 2008-240007

[Patent Document 2] Japanese Unexamined Patent Application, First Publication No. 2015-070199

[Patent Document 3] Japanese Unexamined Patent Application, First Publication No. 2013-153157

DISCLOSURE OF INVENTION

TECHNICAL PROBLEM

However, an insulating layer formed of ceramics or the like, and a heat sink formed of metal significantly differ from each other in thermal expansion coefficient. On the other hand, a Au-Sn alloy has high rigidity and poor malleability. Therefore, in a case where the insulating layer and the heat sink are bonded to each other using a Au-Sn alloy, the Au-Sn alloy cannot absorb the difference in heat expansion between the insulating layer and the heat sink caused due to heat generated in a light-emitting element. As a result, there is concern that a crack is generated in the Au-Sn alloy so that the insulating layer and the heat sink are delaminated from each other or a bonding part is damaged. In addition, in a light-emitting module substrate with a cooler, in which a cooler is additionally connected to the heat sink via thermal grease or the like, thermal resistance becomes significant due to the presence of a bonding material such as a Au-Sn alloy or thermal grease, thereby leading to a problem of low heat dissipation characteristics.

The present invention has been made in consideration of the foregoing circumstances, and an object thereof is to provide a light-emitting module with a cooler, in which a bonding part of a material is prevented from being damaged due to heat generated by a light-emitting element and heat dissipation characteristics can be enhanced, and a method of producing a light-emitting module with a cooler.

SOLUTION TO PROBLEM

In order to solve the problems described above, according to the present invention, there is provided a light-emitting module with a cooler according to claim 1.

According to the light-emitting module with a cooler of the present invention, since the metal layer and the cooler are directly bonded to each other, a bonding part between the metal layer and the cooler can be prevented from being delaminated from each other or damaged when a thermal cycle in which the light-emitting element is repetitively turned on and turned off is applied.

That is, in a case where an insulating layer and a cooler are bonded to each other using a bonding material having high rigidity, such as a Au-Sn alloy as in the related art, there are cases where stress caused due to a difference between the thermal expansion coefficients cannot be absorbed, and the insulating layer and the cooler are delaminated from each other. In contrast, according to the present invention, since the metal layer disposed between the insulating layer and the cooler, and the cooler are directly bonded to each other using a brazing material or the like, the cooler and the metal layer are firmly bonded to each other and the bonding part can be reliably prevented from being delaminated from each other.

In addition, since the thickness of the circuit layer is formed to be 0.01 mm to 0.09 mm, it is possible to finely form a circuit pattern for mounting a light-emitting element. Moreover, if the thickness of the circuit layer exceeds 0.1 mm, a stress buffering effect cannot be obtained unless the thickness of the metal layer serving as a stress buffer layer is thickened to 0.6 mm or greater, for example, so that stress is increasingly applied to ceramics and a fracture is generated in the ceramics.

In addition, in the light-emitting module with a cooler according to the present invention, when the area of the light-emitting element is A and the area of the one surface of the insulating layer is B, the ratio of A:B is within a range from 1:20 to 1:400.

If the ratio of A:B falls below 1:20, that is, if the area of the one surface of the insulating layer becomes smaller than the area of the light-emitting element, thermal resistance increases.

If the ratio of A:B exceeds 1:400, that is, if the area of the one surface of the insulating layer becomes greater than the area of the light-emitting element, warp in the light-emitting module with a cooler becomes significant.

Thus, if the ratio of A:B is set within a range from 1:20 to 1:400, heat generated by turning on the light-emitting element can be efficiently propagated toward the cooler, so that it is possible to realize a light-emitting module with a cooler and having excellent cooling performance.

A light-emitting element mounting portion corresponding to the area of the light-emitting element may be formed on the one surface of the circuit layer. The size of the light-emitting element to be mounted may be determined depending on the light-emitting element mounting portion.

In the light-emitting module with a cooler according to an aspect of the present invention, an amount of warp within +25°C to +175°C on an element mounting surface in the circuit layer having the light-emitting element bonded thereto is 5 µm/10 mm or less.

Accordingly, even if a temperature cycle is applied by repetitively turning on and turning off the light-emitting element, it is possible to suppress deterioration of illuminance and fluctuation of an irradiation range caused due to a curve in the light-emitting element.

In the light-emitting module with a cooler according to an aspect of the present invention, a metal block for increasing a heat capacity of the cooler is directly bonded to the cooler.

Since such a metal block is bonded to the cooler, the heat capacity of the cooler can be increased, heat propagated from the metal layer can be more efficiently absorbed, and the cooling ability of the cooler can be further enhanced.

In the light-emitting module with a cooler according to an aspect of the present invention, the cooler includes a recess portion into which at least a part of the metal layer is able to be fitted.

Since the recess portion is formed in the cooler, a side surface of the metal layer along a thickness direction also comes into contact with the cooler. Therefore, cooling characteristics of the cooler can be enhanced. In addition, since a part of the metal layer is able to be fitted into the recess portion, the side surface of the metal layer along the thickness direction also comes into contact with the cooler and is fixed, and the strength of the light-emitting module with a cooler can be enhanced.

In the light-emitting module with a cooler according to an aspect of the present invention, the circuit layer and the light-emitting element are bonded to each other via a Ag layer.

Since the circuit layer and the light-emitting element are bonded to each other using Ag having low electrical resistance, the circuit layer and the light-emitting element are reliably bonded to each other, and it is possible to reduce the electrical resistance between the circuit layer and the light-emitting element.

In the light-emitting module with a cooler according to an aspect of the present invention, the circuit layer and the light-emitting element are bonded to each other via a Au-Sn alloy layer.

Since the circuit layer and the light-emitting element are bonded to each other using a Au-Sn alloy having low electrical resistance and high rigidity, the circuit layer and the light-emitting element are reliably bonded, and it is possible to reduce the electrical resistance between the circuit layer and the light-emitting element.

According to the present invention, there is furthermore provided a method of producing a light-emitting module with a cooler according to claim 6. The circuit layer is formed of a material of any one of the group consisting of copper, a copper alloy, aluminum, and an aluminum alloy and has a thickness of 0.01 mm to 0.09 mm. The metal layer and the cooler are formed of aluminum or an aluminum alloy. The ratio of the area of the light-emitting element to the area of the one surface of the insulating layer is within a range from 1:20 to 1:400. The method includes a bonding step of directly bonding the metal layer and the cooler to each other.

According to the method of producing a light-emitting module with a cooler of the present invention, since the method includes the step of directly bonding the metal layer and the cooler to each other using a brazing material or the like, it is possible to produce a light-emitting module with a cooler, in which the cooler and the metal layer are firmly bonded to each other and the bonding part can be reliably prevented from being delaminated from each other.

In the method of producing a light-emitting module with a cooler according to an aspect of the present invention, the bonding step is a step of bonding the metal layer and the cooler to each other using an Al-Si-based brazing material. Since an Al-Si-based brazing material is used for directly bonding the metal layer and the cooler to each other, it is possible to enhance diffusion properties of the brazing material on each bonding surface of the metal layer and the cooler, and it is possible to directly bond the metal layer and the cooler to each other in an extremely firm manner.

ADVANTAGEOUS EFFECTS OF INVENTION

According to the present invention, it is possible to provide the light-emitting module with a cooler, in which the bonding part is prevented from being damaged due to heat generated by the light-emitting element and heat dissipation characteristics can be enhanced, and the method of producing a light-emitting module with a cooler.

BRIEF DESCRIPTION OF DRAWINGS

FIG. 1 is a cross-sectional view showing an LED module of a first embodiment.
FIG. 2 is a plan view showing the LED module of the first embodiment.
FIG. 3 is a cross-sectional view showing an LED module of a second embodiment.
FIG. 4 is a cross-sectional view showing an LED module of a third embodiment.
FIG. 5 is a plan view showing the LED module of the third embodiment.
FIG. 6 is a cross-sectional view showing an LED module of a fourth embodiment.
FIG. 7 is a cross-sectional view showing a method of producing an LED module having a cooler in stages.

BEST MODE FOR CARRYING OUT THE INVENTION

Hereinafter, with reference to the drawings, a light-emitting module with a cooler, and a method of producing a light-emitting module with a cooler of the present invention will be described. The following embodiments are described in detail for better understanding of the gist of the invention, and the embodiments do not limit the present invention unless otherwise specified. In addition, in the drawings used in the description below, in order to make the features of the present invention easy to understand, there are cases where main parts are enlarged for convenience, and the dimensional ratio and the like of each of constituent elements are not necessarily the same as those of the actual configuration.

(First Embodiment)

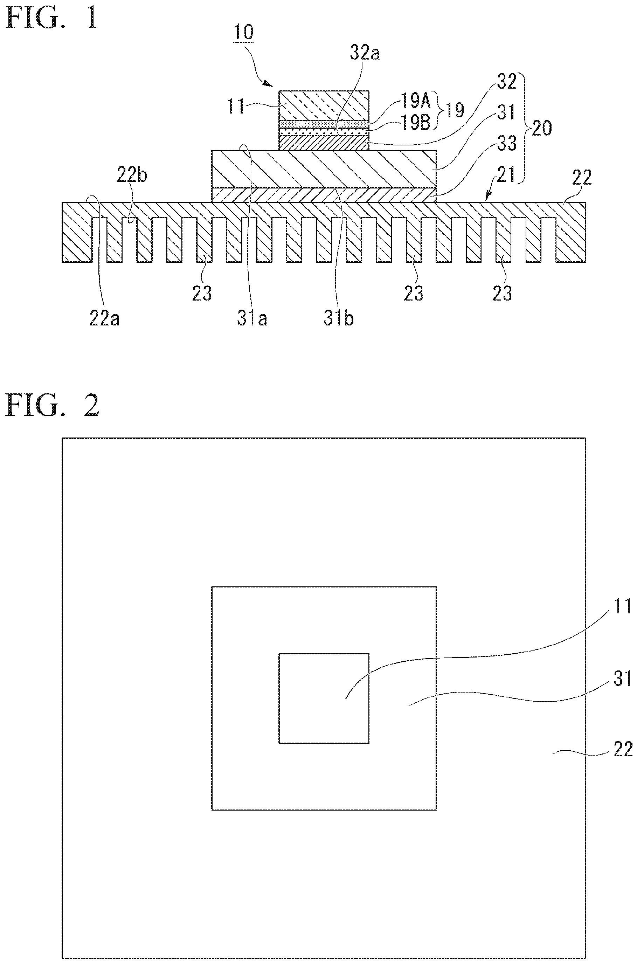

A light-emitting module (LED module) of a first embodiment will be described with reference to FIG. 1.
FIG. 1 is a cross-sectional view showing the light-emitting module (LED module) of the first embodiment of the present invention. FIG. 2 is a plan view showing the LED module of the first embodiment of the present invention.
An LED module 10 includes a light-emitting element 11 (LED element 11) and an LED module substrate with a cooler 20.
The light-emitting element 11 can be an LED element, a laser diode element, a semiconductor laser element, or the like.
In the present embodiment, an LED element is used as the light-emitting element 11.
The LED module substrate with a cooler 20 has an insulating layer 31 which is a substrate having insulating properties, a circuit layer 32 which is laminated on one surface (surface on one side) side 31a of the insulating layer 31, a metal layer 33 which is laminated on the other surface (surface on the other side) side 31b of the insulating layer 31, and a cooler 21 which is directly bonded to the metal layer 33.
For example, the insulating layer 31 is formed of ceramics, such as $Si_3N_4$ (silicon nitride), AlN (aluminum nitride), and $Al_2O_3$ (alumina), having excellent insulating properties and heat dissipation properties.
In the present embodiment, the insulating layer 31 is formed of AlN. In addition, for example, the thickness of the insulating layer 31 is set within a range from 0.2 to 1.5 mm. In the present embodiment, the thickness thereof is set to 0.635 mm.
The circuit layer 32 is a conductive plate electrically connected to the LED element 11. The circuit layer 32 is formed of aluminum, copper, or an alloy thereof having excellent conductivity. In the present embodiment, the circuit layer 32 is formed of an aluminum plate having a purity of 99.0 mass% or more. The circuit layer 32 is formed to have a thickness of 0.01 mm to 0.09 mm. If the thickness of the circuit layer 32 exceeds 0.1 mm, it is not possible to finely form a circuit pattern for mounting an LED element. In addition, a stress buffering effect decreases unless the thickness of the metal layer 33 serving as a stress buffer layer (will be described below) is thickened to 0.6 mm, greater or the like, for example, so that stress is increasingly applied to ceramics and a fracture is generated in the ceramics. The thickness of the circuit layer 32 preferably ranges from 0.01 mm to 0.07 mm, but is not limited thereto.
An element mounting surface 32a in such a circuit layer 32 having the LED element 11 bonded thereto is formed such that the amount of warp is 5 μm/10 mm or less (the amount of warp per length of 10 mm is 5 μm or less) within a temperature range from +25°C to +175°C. Since the amount of warp on the element mounting surface 32a of the circuit layer 32 is set to 5 μm/10 mm or less, the bonding strength between the circuit layer 32 and the LED element 11 is enhanced. In addition, the amount of warp on the element mounting surface 32a of the circuit layer 32 is caused to be 5 μm/10 mm or less. Then, within the temperature range from +25°C to +175°C, curving stress applied to the LED element 11 is suppressed, and damage to the LED element 11 due to a curve and deterioration of illuminance are prevented. The amount of warp on the element mounting surface 32a within the range from +25°C to +175°C preferably ranges from 0 μm/10 mm to 3 μm/10 mm but is not limited thereto. In order to have the amount of warp on the element mounting surface 32a within the range described above, for example, bonding is performed using a tool for causing the element mounting surface 32a side to have a recessed shape at the time of bonding, and the amount of warp after being cooled to room temperature is controlled to be within the range.
The insulating layer 31 and the circuit layer 32 are directly bonded to each other using a brazing material. Examples of the brazing material include an Al-Cu-based brazing material and an Al-Si-based brazing material. In the present embodiment, an Al-Si-based brazing material is used. In the circuit layer 32, a predetermined circuit pattern can be formed through etching, for example, after a conductive metal plate is bonded to the insulating layer 31 using the brazing material.
The metal layer 33 is formed of aluminum or an aluminum alloy. In the present embodiment, a plate-shaped member formed of high purity aluminum having a purity of 99.98 mass% or higher is used as the metal layer 33. The thickness of the metal layer 33 ranges from 0.9 mm to 1.6 mm. The metal layer 33 functions as the stress buffer layer by forming such a metal layer 33 between the insulating layer 31 and the cooler 21. That is, since the metal layer 33 is formed, it is possible to absorb the thermal stress caused due to a difference between the thermal expansion coefficients of the insulating layer 31 formed of ceramics and the cooler 21 formed of aluminum or an aluminum alloy and to prevent damage to the insulating layer 31.

In addition, if the metal layer 33 is formed of high purity aluminum having a purity of 99.98 mass% or higher, deformation resistance is reduced, so that when a thermal cycle in which the LED element 11 is repetitively turned on and turned off is applied, thermal stress generated in the insulating layer 31 can be effectively absorbed by the metal layer 33.

The insulating layer 31 and the metal layer 33 are directly bonded to each other using a brazing material. Examples of the brazing material include an Al-Cu-based brazing material and an Al-Si-based brazing material. In the present embodiment, an Al-Si-based brazing material is used.

For example, the cooler 21 is a member which cools heat generated by emitted light of the LED element 11 through active heat exchange by causing a refrigerant such as gas or liquid to circulate in flow channels. The cooler 21 includes the flow channels in which the refrigerant circulates, fins for increasing the surface area in contact with the refrigerant, and the like. Therefore, the cooler 21 is a member formed to have a shape more suitable for heat exchange than a heat sink having a simple plate shape, and the like.

The cooler 21 of the present embodiment is configured to include a top plate portion 22 and a plurality of fins 23 formed on the other surface 22b of in the top plate portion 22. The fins 23 are plate-shaped members disposed at predetermined intervals from each other. The cooler 21 is a so-called air cooling-type cooler in which air (refrigerant) circulates in gaps (flow channels) among the fins 23 so that heat generated due to light emitted by the LED element 11 is efficiently cooled.

For example, the cooler 21 may be a so-called water cooling-type cooler in which a plurality of flow channels for circulating cooling water, for example, are integrally formed with the top plate portion 22.

For example, the top plate portion 22 and the fins 23 configuring the cooler 21 are formed of aluminum or an aluminum alloy. Specifically, examples thereof include A3003, A1050, 4N-Al, and A6063. In the present embodiment, a rolled sheet of A1050 is used. The top plate portion 22 and the fins 23 may be configured to be formed as an integrated member, or the plurality of fins 23 may be configured to be bonded to the other surface 22b of the top plate portion 22 using a brazing material or the like. In a case where the top plate portion 22 and the plurality of fins 23 are configured to be different members, the top plate portion 22 and the plurality of fins 23 may be formed using materials of which A1 compositions are different from each other. For example, the top plate portion 22 may be formed of A3003 and the plurality of fins 23 may be formed of A1050.

The metal layer 33 and one surface 22a of the top plate portion 22 are directly bonded to each other. As a method of directly bonding the metal layer 33 and the top plate portion 22 to each other, for example, it is possible to apply direct-bonding using an Al-Si-based brazing material. In a case where an Al-Si-based brazing material is used, for example, an Al-Si-based brazing material foil is disposed between the metal layer 33 and the one surface 22a of the top plate portion 22 and is heated at approximately 640°C. Then, the Al-Si-based brazing material is diffused in the metal layer 33 and the top plate portion 22, and the metal layer 33 and the top plate portion 22 are directly bonded to each other. Direct-bonding is bonding performed through brazing, and it is preferable that a eutectic structure is formed on a bonding interface.

As another method of directly bonding the metal layer 33 and the top plate portion 22 to each other, it is possible to perform bonding through brazing using an Al-Si-based brazing material and a flux containing F (fluorine), for example, a flux having $KAlF_4$ as a main component. In a case where a flux is used, there is no need to eliminate oxide films of the metal layer 33 and the top plate portion 22 at the time of bonding.

As further another method of directly bonding the metal layer 33 and the top plate portion 22 to each other, bonding can be performed through flux-less brazing in which brazing is performed using an Al-Si-Mg-based brazing material in a nitrogen atmosphere.

The LED module 10 is obtained by installing the LED element 11 with respect to the LED module substrate with a cooler 20 having the configuration described above.

Such an LED element 11 is bonded to (installed in) the element mounting surface 32a of the circuit layer 32 via a Ag layer 19. For example, the Ag layer 19 is formed of a sintered body of Ag powder. In the present embodiment, the Ag layer 19 includes two layers (Ag bonding layer 19A and Ag-baked layer 19B). The Ag-baked layer 19B is preferably realized by coating the surface of the circuit layer 32 with a paste formed of Ag powder and glass powder, and drying and baking the coated surface. In addition, the Ag bonding layer 19A may be sintered at a temperature of 300°C or lower. For example, the Ag bonding layer 19A is coated with pasted nano-Ag powder, is sintered, and is bonded.

In addition, in the LED module 10, the area of the LED element 11 is A and the area of the one surface of the insulating layer 31 is B, the ratio of A:B is set within a range from 1:20 to 1:400. If the ratio of A:B falls below 1:20, that is, if the area of the one surface of the insulating layer 31 becomes smaller than the area of the LED element 11, thermal resistance increases. If the ratio of A:B exceeds 1:400, that is, if the area of the one surface of the insulating layer 31 becomes greater than the area of the LED element 11, warp in the LED module with a cooler becomes significant. Thus, if the ratio of A:B is set within a range from 1:20 to 1:400, heat generated by turning on the LED element 11 can be efficiently propagated toward the cooler 21, so that it is possible to realize an LED module with a cooler having excellent cooling performance. The ratio of A:B preferably ranges from 1:30 to 1:200, and more preferably ranges from 1:50 to 1:150, but is not limited thereto.

In a case where a plurality of LED elements 11 are bonded to the circuit layer 32, the area A of the LED element 11 is the total sum of the areas of the bonded LED elements 11. In addition, a light-emitting element mounting portion corresponding to the area A of the LED element 11 may be formed on the one surface of the circuit layer 32. The size of the light-emitting element 11 to be mounted may be determined depending on the light-emitting element mounting portion.

According to the LED module 10 having the configuration described above, and the LED module substrate with a cooler 20 configuring the LED module 10, since the metal layer 33 and the cooler 21 are directly bonded to each other, it is possible to prevent a bonding part between the metal layer 33 and the cooler 21 from being delaminated from each other or damaged when a thermal cycle in which the LED element 11 is repetitively turned on and turned off is applied.

That is, in a case where an insulating layer and a cooler are bonded to each other using a bonding material having high rigidity, such as a Au-Sn alloy, as in the related art, there are cases where stress caused due to a difference between the thermal expansion coefficients cannot be absorbed, and the insulating layer and the cooler are delaminated from each other. In contrast, according to the present embodiment, since the metal layer 33, which is disposed between the insulating layer 31 and the cooler 21, and the cooler 21 are directly bonded to each other using a brazing material or the like, the cooler 21 and the metal layer 33 are firmly bonded to each other, and the bonding part can be reliably prevented from being delaminated from each other.

In addition, since the metal layer 33 serving as a stress buffer layer is provided between the insulating layer 31 and the cooler 21, thermal stress generated in the insulating layer 31 can be effectively absorbed by the metal layer 33, and a crack or a fracture can be prevented from being caused in the insulating layer 31.

(Second Embodiment)

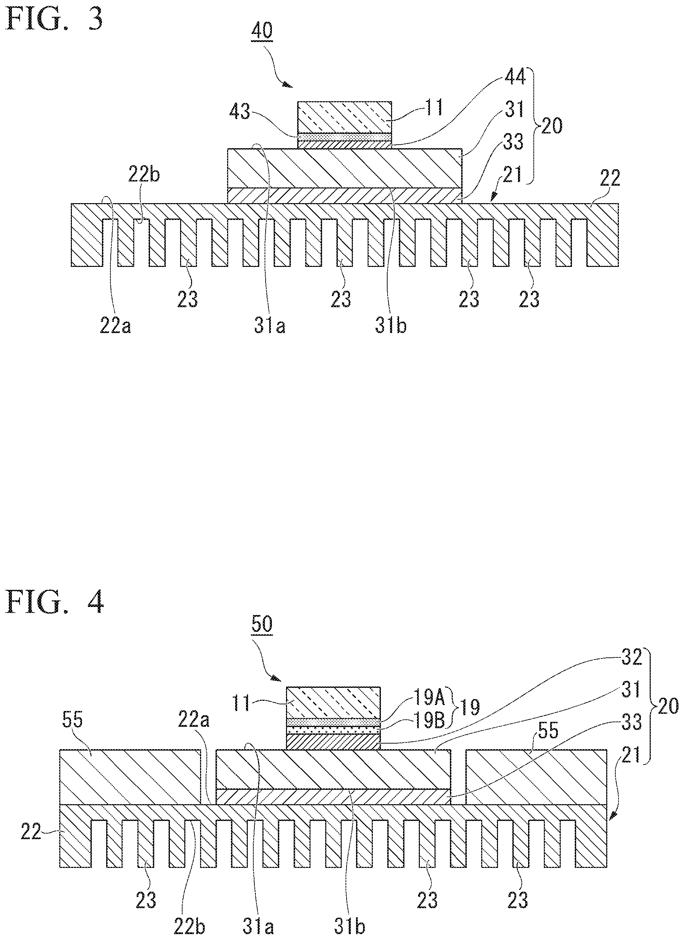

A light-emitting module (LED module) of a second embodiment will be described with reference to FIG. 3.

FIG. 3 is a cross-sectional view showing the LED module of the second embodiment of the present invention. The same reference signs are applied to members having the same configuration as the LED module of the first embodiment, and a detailed description of the structures and operations thereof will be omitted.

An LED module 40 of the second embodiment includes the light-emitting element 11 (LED element 11) and the LED module substrate with a cooler 20. The LED module substrate with a cooler 20 has the insulating layer 31 which is a substrate having insulating properties, a circuit layer 44 which is laminated on the one surface (surface on one side) side 31a of the insulating layer 31, and the metal layer 33 and the cooler 21 which are laminated in order on the other surface (surface on the other side) side 31b of the insulating layer 31.

In the LED module 40 of the second embodiment, the LED element 11 is bonded to (installed in) the circuit layer 44 constituted of a Cu plate via a Au-Sn alloy layer 43. That is, the circuit layer 44 of this embodiment is formed using a copper plate having high adhesion with respect to the Au-Sn alloy layer 43.

The Au-Sn alloy layer 43 is formed causing a Au-Sn alloy solder (for example, Au-20 mass% Sn) to melt at approximately 330°C. In addition, a copper plate having a thickness ranging from approximately 40 to 85 μm can be used as the circuit layer 44.

In such an LED module 40 as well, a bonding part between the insulating layer 31 formed of ceramics, and the cooler 21 formed of Al or an Al alloy can be prevented from being damaged when a thermal cycle in which the LED element 11 is repetitively turned on and turned off is applied, by directly bonding the metal layer 33, which is disposed between the insulating layer 31 and the cooler 21 having thermal expansion coefficients significantly different from each other, and the cooler 21 using a Si-Al brazing material, for example.

In the LED module 40 of the second embodiment, the LED element 11 is bonded to the circuit layer 44 using the Au-Sn alloy layer 43 having high rigidity. However, since the bonding part of the LED element 11 has a small area and the influence of thermal stress caused due to a difference in thermal expansion coefficient with respect to the circuit layer 44 side is small, the risk of damage to the Au-Sn alloy layer 43 due to the load of the thermal cycle is small.

(Third Embodiment)

A light-emitting module (LED module) of a third embodiment will be described with reference to FIG. 4.

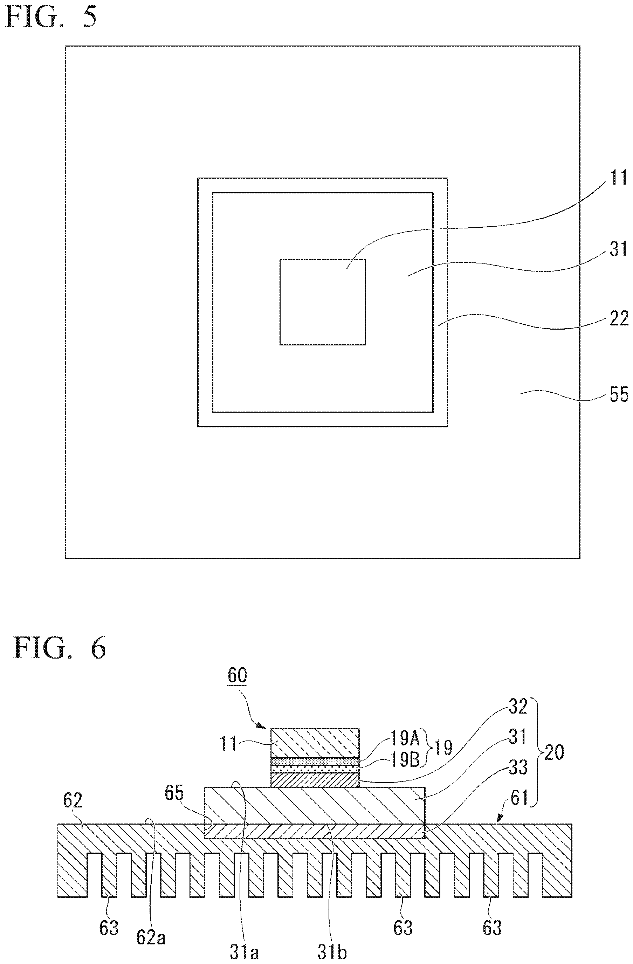

FIG. 4 is a cross-sectional view showing the LED module of the third embodiment of the present invention. FIG. 5 is a plan view showing the LED module of the third embodiment of the present invention. The same reference signs are applied to members having the same configuration as the LED module of the first embodiment, and a detailed description of the structures and operations thereof will be omitted.

An LED module 50 of the third embodiment includes the LED element 11 and the LED module substrate with a cooler 20. The LED module substrate with a cooler 20 includes the insulating layer 31 which is a substrate having insulating properties, the circuit layer 32 which is laminated on the one surface (surface on one side) side 31a of the insulating layer 31, and the metal layer 33 and the cooler 21 which are laminated in order on the other surface (surface on the other side) side 31b of the insulating layer 31.

In the LED module 50 of the third embodiment, a metal block 55 is bonded to a location outside a region to which the metal layer 33 is directly bonded on the one surface 22a of the top plate portion 22 of the cooler 21 which is directly bonded to the metal layer 33. Similar to the cooler 21, the metal block 55 is formed of aluminum or an aluminum alloy. The heat capacity of the cooler 21 can be increased by bonding the metal block 55 to the one surface 22a of the cooler 21. Thus, heat generated by turning on the LED element 11 is more efficiently absorbed, and the cooling ability of the cooler 21 can be further enhanced.

The one surface 22a of the cooler 21 and the metal block 55 are bonded to each other through direct-bonding. In the present embodiment, the cooler 21 and the metal block 55 are directly bonded to each other using an Al-Si-based brazing material. In addition, the cooler 21 and the metal block 55 can be directly bonded to each other through brazing using a flux having $KAlF_4$ as a main component or can be directly bonded to each other through flux-less brazing using an Al-Si-Mg-based brazing material in a nitrogen atmosphere.

(Fourth Embodiment)

A light-emitting module (LED module) of a fourth embodiment will be described with reference to FIG. 6.

FIG. 6 is a cross-sectional view showing the LED module of the fourth embodiment of the present invention. The same reference signs are applied to members having the same configuration as the LED module of the first embodiment, and a detailed description of the structures and operations thereof will be omitted.

An LED module 60 of the fourth embodiment includes the LED element 11 and the LED module substrate with a cooler 20. The LED module substrate with a cooler 20 includes the insulating layer 31 which is a substrate having insulating properties, the circuit layer 32 which is laminated on the one surface (surface on one side) side 31a of the insulating layer 31, and the metal layer 33 and a cooler 61 which are laminated in order on the other surface (surface on the other side) side 31b of the insulating layer 31.

In the LED module 60 of the fourth embodiment, a recess portion 65 into which at least a part of the metal layer 33 can be fitted is formed in the cooler 61. That is, the cooler 61 is configured to include a top plate portion 62 and a plurality of fins 63 formed in the top plate portion 62. The recess portion 65 is formed to be grooved from one surface side 62a of the top plate portion 62 toward the fins 63.

Such a recess portion 65 need only be formed to have a size such that at least a part of the metal layer 33 can be accommodated therein. In the present embodiment, the recess portion 65 is formed to have a depth such that a part near the bonding surfaces of the metal layer 33 and the insulating layer 31 can be accommodated. In addition, in regard to the shape of the recess portion 65, its side surface is formed to have a shape being in contact with a side surface of the metal layer 33 in the thickness direction.

As in the present embodiment, since the recess portion 65 is formed in the cooler 61, the side surface of the metal layer 33 along the thickness direction also comes into contact with the cooler 61. Therefore, cooling characteristics of the cooler 61 can be further enhanced. In addition, since the side surface of the metal layer 33 is accommodated in the recess portion 65, the metal layer 33 is more stably fixed to the cooler 61, and the strength of the LED module substrate with a cooler 20 can be enhanced.

(Method of Producing Light-emitting Module With Cooler)

An example of a method of producing an LED module with a cooler of the present invention will be described.

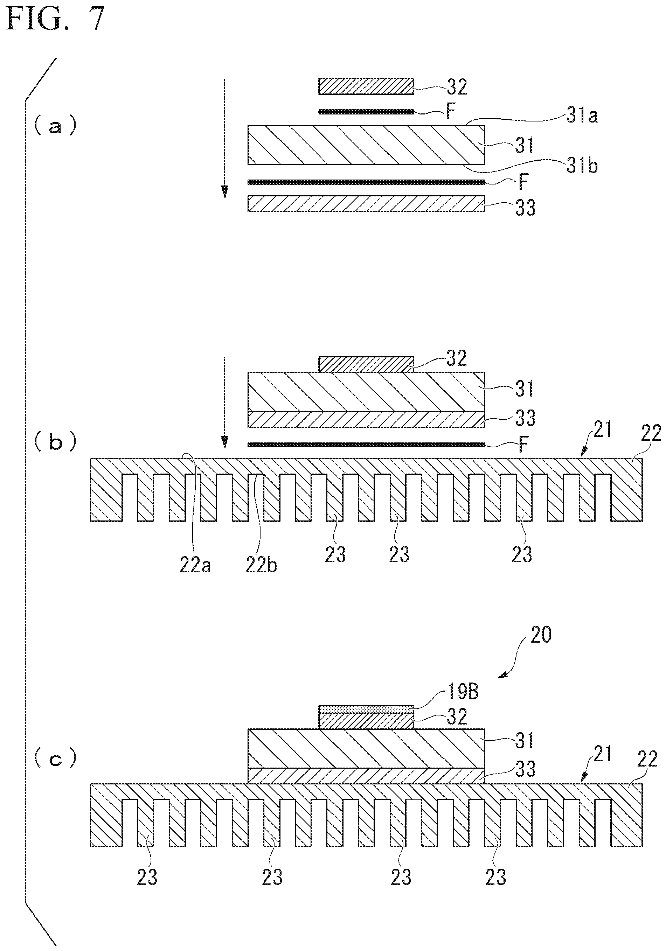

FIG. 7 is a cross-sectional view showing an example of the method of producing an LED module with a cooler in stages.

When an LED module having a cooler of the present invention is produced, first, the circuit layer 32 is bonded to the one surface (surface on one side) side 31a of the insulating layer 31, and the metal layer 33 is bonded to the other surface (surface on the other side) side 31b of the insulating layer 31 (refer to FIG. 7(a)). For example, 4N-Al having a thickness of 0.01 mm to 0.09 mm can be used as the circuit layer 32.

In regard to bonding, a brazing material foil F is individually disposed between the insulating layer 31 and the circuit layer 32, and between the insulating layer 31 and the metal layer 33. The laminated matter is heated to a melting temperature of the brazing material foil F while being pressurized in a lamination direction. For example, an Al-Si-based brazing material can be used as the brazing material foil F. For example, a heating temperature at the time of bonding may be set to 640°C. Accordingly, the circuit layer 32 and the metal layer 33 are directly bonded to the insulating layer 31.

Next, a brazing material foil F is disposed between the metal layer 33 and the cooler 21 formed of Al or an Al alloy. The laminated matter is heated to a melting temperature of the brazing material foil F while being pressurized in a lamination direction. For example, an Al-Si-based brazing material can be used as the brazing material foil F. For example, a heating temperature at the time of bonding may be set to 640°C. Accordingly, the metal layer 33 and the cooler 21 are directly bonded to each other (bonding step: refer to FIG. 7(b)).

The metal layer 33 and the cooler 21 can be directly bonded to each other through brazing using a flux having $KAlF_4$ as a main component or can be directly bonded to each other through flux-less brazing using an Al-Si-Mg-based brazing material in a nitrogen atmosphere.

Next, the circuit layer 32 is coated with a glass-containing Ag paste and is baked at a temperature ranging from 567°C to 620°C, thereby forming a Ag sintered body constituted of the Ag-baked layer 19B (refer to FIG. 7(c)). The glass-containing Ag paste contains Ag powder, glass powder, a resin, a solvent, and a dispersant. The paste has an amount of the powder component constituted of Ag powder and glass powder set within a range from 60 mass% to 90 mass% of the glass-containing Ag paste in its entirety, and the remainder of the resin, the solvent, and the dispersant. A matter with a particle size ranging from 0.05 $\mu$m to 1.0 $\mu$m can be used as the Ag powder. For example, the glass powder contains any one, or two or more of lead oxide, zinc oxide, silicon oxide, boron oxide, phosphorus oxide, and bismuth oxide. A matter having a softening temperature of 600°C or lower can be used as the glass powder. It is favorable to have the weight ratio A/G of a weight A of the Ag powder and a weight G of the glass powder within a range from 80/20 to 99/1.

The LED module substrate with a cooler 20 shown in FIG. 1 can be obtained through the step described above.

When the light-emitting element 11 (in the present embodiment, the LED element 11) is installed in the circuit layer 32 of the LED module substrate with a cooler 20, for example, a Ag paste containing Ag particles with a particle size ranging from 50 nm to 350 nm is interposed between the LED element 11 and the Ag-baked layer 19B and is baked at a temperature ranging from 200°C to 300°C, and then the LED element 11 can be installed on the Ag-baked layer 19B via the Ag bonding layer 19A. In this case, the LED element 11 is bonded to the circuit layer 32 via the Ag layer 19.

Hereinabove, some embodiments of the present invention have been described. However, each of the embodiments is provided as an example and is not intended to limit the scope of the invention. Each of the embodiments can be realized in other various forms, and various omissions, replacements, additions, and changes can be made within a range not departing from the scope of the invention as defined by the claims.

EXAMPLES

Hereinafter, experimental examples in which the effects of the present embodiment have been verified will be described.

[Example 1, not forming part of the present invention]

A 4N-Al plate (thickness of 0.1 mm) was bonded to one surface side of an AlN substrate (10 mm×10 mm, insulating layer) having a thickness of 1.0 mm, and a 4N-Al plate (thickness of 1.5 mm) was bonded to the other surface side of the AlN substrate (insulating layer). In bonding, an Al-Si-based brazing material foil was used and was caused to melt at 640°C, and direct-bonding was performed. Thereafter, an LED element circuit was formed through etching on the surface of the 4N-Al plate bonded to the one surface side of the AlN substrate, and a circuit layer was obtained. Next, a cooler formed of Al (A1050) was directly bonded to the surface of the 4N-Al plate (metal layer) bonded to the other surface side of the AlN substrate. In bonding, an Al-Si-based brazing material foil was used and was caused to melt at 610°C, and direct-bonding was performed. Moreover, the circuit layer was coated with a glass-containing Ag paste disclosed in the embodiment and was baked at 500°C, and a Ag-baked layer was formed. Thereafter, the LED element was bonded to the circuit layer at 200°C using the Ag paste disclosed in the embodiment. Consequently, an LED module of Example 1 was obtained.

[Example 2]

A Cu thin-plate (thickness of 0.05 mm) was bonded to one surface side of an AlN substrate (insulating layer) having a thickness of 1.0 mm at 820°C using an active metal brazing material (Ag-Cu-Ti), and then a 4N-Al plate (thickness of 1.5 mm) was directly bonded to the other surface side using an Al-Si-based brazing material foil caused to melt at 640°C. Thereafter, an LED element circuit was formed through etching on the surface of the Cu thin-plate bonded to the one surface side of the AlN substrate, and a circuit layer was obtained. Next, the cooler formed of Al (A1050) was directly bonded to the surface of the 4N-Al plate (metal layer) bonded to the other surface side of the AlN substrate. In bonding, an Al-Si-Mg-based brazing material foil was used and was caused to melt at 610°C in a nitrogen atmosphere and direct-bonding was performed. Moreover, the LED element was bonded to the circuit layer at 330°C using a Au-Sn alloy solder. Accordingly, an LED module Example 2 was obtained.

[Example 3, not forming part of the present invention]

A Ag-Pd thick film paste was printed on one surface side of the AlN substrate (insulating layer) having a thickness of 1.0 mm and was dried. Then, the Ag-Pd thick film paste was baked at 850°C in the atmosphere, and a Ag-Pd thick film circuit (thickness of 0.01 mm) was formed. Thereafter, the 4N-Al plate (thickness of 1.5 mm) was directly bonded to the other surface side of the AlN substrate (insulating layer) using an Al-Si-based brazing material foil caused to melt at 640°C, and an LED module substrate was obtained. Thereafter, a metal layer of the LED module substrate was laminated toward a cooler via the Al-Si-based brazing material foil on the cooler, and a metal block (A6063 alloy, thickness of 2.5 mm) was laminated via the Al-Si-based brazing material foil and was bonded thereto at 610°C. Moreover, the circuit layer was coated with the Ag paste disclosed in the embodiment, and the LED element was mounted on the coated Ag paste. The LED element was bonded to the circuit layer by sintering them at 200°C. Consequently, an LED module of Example 3 was obtained.

[Example 4, not forming part of the present invention]

A Cu thin-film circuit (thickness of 0.005 mm) was formed on one surface side of an AlN substrate (insulating layer) having a thickness of 1.0 mm by performing plating after sputtering, and then a 4N-Al plate (thickness of 1.5 mm) was directly bonded to the other surface side using an Al-Si-based brazing material foil caused to melt at 640°C. Thereafter, an LED element circuit was formed through etching on the surface of the Cu thin-plate bonded to the one surface side of the AlN substrate, and a circuit layer was obtained. Next, the cooler formed of Al (A1050) and having a groove portion (recess portion) was directly bonded to the surface of the 4N-Al plate (metal layer) bonded to the other surface side of the AlN substrate. In bonding, an Al-Si-Mg-based brazing material foil was used and was caused to melt at 610°C in a nitrogen atmosphere and direct-bonding was performed. Moreover, the LED element was bonded to the circuit layer at 330°C using a Au-Sn alloy solder. Accordingly, an LED module of Example 4 was obtained.

[Example 5, not forming part of the present invention]

The shape of the AlN substrate in Example 1 was changed to 5 mm×4 mm, and an LED module of Example 5 was obtained.

[Example 6, not forming part of the present invention]

The shape of the AlN substrate in Example 1 was changed to 20 mm×20 mm, and an LED module of Example 6 was obtained.

[Comparative Example 1, not forming part of the present invention]

Cu thin-plates (thickness of 0.05 mm) were bonded to both surfaces of an AlN substrate (insulating layer) having a thickness of 1.0 mm at 820°C using an active metal brazing material (Ag-Cu-Ti). Thereafter, an LED element circuit was formed through etching on the surface of the Cu thin-plate bonded to the one surface side of the AlN substrate, and a circuit layer was obtained. Next, the LED element was bonded to the circuit layer at 330°C using a Au-Sn alloy solder. This was attached to the cooler using grease (G-747, manufactured by SHIN-ETSU Chemical Co., Ltd.), and an LED module of Comparative Example 1 was obtained.

[Comparative Example 2, not forming part of the present invention]

Cu thin-plates (thickness of 0.05 mm) were bonded to both surfaces of an AlN substrate (insulating layer) having a thickness of 1.0 mm at 820°C using an active metal brazing material (Ag-Cu-Ti). Thereafter an LED element circuit was formed through etching on the surface of the Cu thin-plate bonded to the one surface side of the AlN substrate, and a circuit layer was obtained. Next, the LED element was bonded to the circuit layer at 330°C using a Au-Sn alloy solder. This was bonded to the cooler using a Sn-Ag-Cu solder, and an LED module of Comparative Example 2 was obtained.

[Comparative Example 3, not forming part of the present invention]

A 4N-Al plate (thickness of 0.2 mm) was bonded to one surface side of an AlN substrate (3 mm×3 mm) (insulating layer) having a thickness of 1.0 mm, and a 4N-Al plate (thickness of 1.5 mm) was bonded to the other surface side of the AlN substrate (insulating layer). In bonding, an Al-Si-based brazing material foil was used and was caused to melt at 640°C, and direct-bonding was performed. Thereafter, an LED element circuit was formed through etching on the front surface of the 4N-Al plate bonded to the one surface side of the AlN substrate, and a circuit layer was obtained. Next, a cooler formed of Al (A1050) was directly bonded to the front surface of the 4N-Al plate (metal layer) bonded to the other surface side of the AlN substrate. In bonding, an Al-Si-based brazing material foil was used and was caused to melt at 610°C, and direct-bonding was performed. Moreover, the circuit layer was coated with a glass-containing Ag paste disclosed in the embodiment and was baked at 500°C, and a Ag-baked layer was formed. Thereafter, the LED element was bonded to the circuit layer at 200°C using the Ag paste disclosed in the embodiment. Consequently, an LED module of Comparative Example 3 was obtained.

[Comparative Example 4, not forming part of the present invention]

The shape of AlN in Comparative Example 3 was changed to 30 mm×30 mm, and an LED module of Comparative Example 4 was obtained.

[Evaluation]

Bonding properties, thermal resistance, and a warp after a temperature cycle were evaluated using each of the LED modules of Examples 1 to 6 and Comparative Examples 1 to 4 described above.

(Bonding Properties after Temperature Cycle)

A temperature cycle test was performed 2,000 for cycles on a temperature cycle of -40°C for 30 minutes and +175°C for 30 minutes with respect to each of the LED modules using a gas-phase temperature-cycle tester (TSD-100, manufactured by ESPEC Corp.). After 2,000 cycles, bonding properties between the element and the circuit layer bonding portion, and between the metal layer and the cooler bonding portion were evaluated by calculating a bonding area from the following expression indicating the bonding area, and using an ultrasonic inspection system (FineSAT FS200, manufactured by HITACHI Construction Machinery Co., Ltd.). In this case, the initial bonding area means the area ought to be bonded before bonding was performed, that is, the area of the element in a case of evaluation between the element and the circuit layer bonding portion, and the area of the metal layer in a case of evaluation between the metal layer and the cooler bonding portion. Since a delaminated portion was indicated in white in an image which was an ultrasonic-flaw detection image subjected to binarization processing, the white area was considered as the delaminated area.

$$\text{Bonding area (\%)} = \{(\text{initial bonding area}) - (\text{delaminated area})\}/(\text{initial bonding area}) \times 100$$

A case where the bonding area after a cycle was less than 60% of the bonding area before the cycle was evaluated as C, a case where the same ranged from 60% to less than 80% was evaluated as B, and a case where the same was 80% or greater was evaluated as A.

(Thermal resistance)

The fins of the cooler of the LED module were cooled with a fan, and a current was caused to flow in the LED element to have a calorific value of 16W. When the difference between the temperature of the LED element and the atmosphere temperature (ambient temperature) at that time was $\Delta T$, thermal resistance was calculated as follows: $\Delta T$ (°C)/calorific value (W). The applied voltage was 12V, and the temperature of the element was 70°C. The temperature was measured in a steady state after five minutes using a thermo-viewer.

(Warp)

The maximum warp in the LED module when heated from +25°C to +175°C was measured using TherMoire (manufactured by Akrometrix, LLC), and the amount of warp per 10 mm was measured. The measurement was performed from the top of the circuit layer, and the warp was warp in the circuit layer. The evaluation result thereof is indicated in Table 1.

[Table 1]

| | Structure of package | | | | | | | | | | Evaluation result | | | |
|---|---|---|---|---|---|---|---|---|---|---|---|---|---|---|
| | Element bonding material | Circuit layer material | Thickness (mm) | | | Method of bonding cooler | Structure of cooler | Shape of element (mm) | Size of insulating layer (mm) | Area ratio (element area/insulating layer area) | Temperature cycle | | Thermal resistance | Warp |
| | | | Circuit layer | AlN substrate | Metal layer | | | | | | Element bonding portion | Cooler bonding portion | (°C/W) | (μm/10 mm) |
| Example 1 | Ag | 4N-Al | 0.10 | 1.0 | 1.5 | Brazing | A1050 pin fins | 1.0×1.0 | 10×10 | 1:100 | A | A | 5.0 | 2.0 |
| Example 2 | Au-20 wt% Sn | Cu | 0.05 | 1.0 | 1.5 | Brazing | A1050 pin fins | 1.0×1.0 | 10×10 | 1:100 | A | A | 5.1 | 2.2 |
| Example 3 | Ag | Ag-Pd | 0.01 | 1.0 | 1.5 | Brazing | A1050 pin fins + block | 1.0×1.0 | 10×10 | 1:100 | A | A | 4.8 | 1.8 |
| Example 4 | Au-20 wt% Sn | Cu | 0.005 | 1.0 | 1.5 | Brazing | A1050 pin fins + grooved portion | 1.0×1.0 | 10×10 | 1:100 | A | A | 4.9 | 1.8 |
| Example 5 | Ag | 4N-Al | 0.10 | 1.0 | 1.5 | Brazing | A1050 pin fins | 1.0×1.0 | 5×4 | 1:20 | A | A | 5.3 | 1.7 |
| Example 6 | Ag | 4N-Al | 0.10 | 1.0 | 1.5 | Brazing | A1050 pin fins | 1.0×1.0 | 20×20 | 1:400 | A | A | 5.0 | 4.3 |
| Comparative Example 1 | Au-20 wt% Sn | Cu | 0.05 | 1.0 | 0.05 | Grease | A1050 pin fins | 1.0×1.0 | 10×10 | 1:100 | A | A | 7.3 | 1.5 |
| Comparative Example 2 | Au-20 wt% Sn | Cu | 0.05 | 1.0 | 0.05 | Soldering | A1050 pin fins | 1.0×1.0 | 10×10 | 1:100 | A | C | 6.7 | 2.5 |
| Comparative Example 3 | Ag | 4N-Al | 0.20 | 1.0 | 1.5 | Brazing | A1050 pin fins | 1.0×1.0 | 3×3 | 1:9 | A | A | 6.0 | 1.8 |
| Comparative Example 4 | Ag | 4N-Al | 0.20 | 1.0 | 1.5 | Brazing | A1050 pin fins | 1.0×1.0 | 30×30 | 1:900 | A | A | 6.5 | 6.5 |

According to the result above, thermal resistance was high in Comparative Example 1 in which grease was used without directly bonding the metal layer and the cooler to each other, and bonding properties between the metal layer and the cooler bonding portion deteriorated in Comparative Example 2 in which soldering was performed.

In addition, when the area of the LED element is A and the area of the one surface of the insulating layer is B, thermal resistance was significant in Comparative Example 3 in which the ratio of A:B was 1:9, that is, below 1:20. In addition, the amount of warp was significant in Comparative Example 4 in which the ratio of A:B was 1:900, that is, over 1:400.

On the other hand, in Examples 1 to 6 in which the metal layer and the cooler were directly bonded to each other and the ratio of A:B was within a range from 1:20 to 1:400, it was checked that it is possible to obtain an LED module having small thermal resistance and a warp and having excellent bonding properties.

INDUSTRIAL APPLICABILITY

According to a light-emitting module with a cooler and a method for a light-emitting module with a cooler of the present invention, it is possible to prevent a bonding part from being damaged due to heat generated by a light-emitting element, and it is possible to enhance heat dissipation characteristics.

REFERENCE SIGNS LIST

10   LED MODULE
11   LED ELEMENT
20   LED MODULE SUBSTRATE WITH COOLER
21   COOLER
31   INSULATING LAYER
32   CIRCUIT LAYER
33   METAL LAYER

**Claims**

1. A light-emitting module (10, 40, 50, 60) with a cooler, comprising:

    a circuit layer (32, 44) which is formed on one surface side (31a) of an insulating layer (31) and on which a semiconductor light-emitting element (11) is mounted; and
    a metal layer (33) and a cooler (21) which are laminated in order on the other surface side (31b) of the insulating layer (31),
    wherein the circuit layer (32, 44) is formed of any one selected from the group consisting of copper, a copper alloy, aluminum, and an aluminum alloy and has a thickness of 0.01 mm to 0.09 mm,
    wherein the metal layer (33) and the cooler (21) are formed of aluminum or an aluminum alloy,
    wherein the metal layer (33) has a thickness of 0.9 mm to 1.6 mm,
    wherein a ratio of an area of the semiconductor light-emitting element (11) to an area of the one surface (31a) of the insulating layer (31) is within a range from 1:20 to 1:400, and
    wherein the metal layer (33) and the cooler (21) are directly bonded to each other.

2. The light-emitting module (50) with a cooler according to Claim 1,
   wherein a metal block (55) for increasing a heat capacity of the cooler (21) is directly bonded to the cooler (21).

3. The light-emitting module (60) with a cooler according to Claim 1,
   wherein the cooler (21) includes a recess portion (65) into which at least a part of the metal layer (33) is able to be fitted.

4. The light-emitting module (10, 50, 60) with a cooler according to any one of Claims 1 to 3,
   wherein the circuit layer (32) and the semiconductor light-emitting element (11) are bonded to each other via an Ag layer (19).

5. The light-emitting module (40) with a cooler according to any one of Claims 1 to 3,
   wherein the circuit layer (44) and the semiconductor light-emitting element (11) are bonded to each other via an Au-Sn alloy layer (43).

6. A method of producing a light-emitting module (10, 40, 50, 60) with a cooler including a circuit layer (32, 44) which is formed on one surface side (31a) of an insulating layer (31) and on which a semiconductor light-emitting element (11) is mounted, and a metal layer (33) and a cooler (21) which are laminated in order on the other surface side (31b) of the insulating layer (31),
wherein the circuit layer (32, 44) is formed of a material of any of copper, a copper alloy, aluminum, and an aluminum alloy and has a thickness of 0.01 mm to 0.09 mm, wherein the metal layer (33) and the cooler (21) are formed of aluminum or an aluminum alloy, wherein the metal layer (33) has a thickness of 0.9 mm to 1.6 mm, and wherein a ratio of an area of the semiconductor light-emitting element (11) to an area of the one surface (31a) of the insulating layer (31) is within a range from 1:20 to 1:400,
the method comprising a bonding step of directly bonding the metal layer (33) and the cooler (21) to each other.

7. The method of producing a light-emitting module (10, 40, 50, 60) with a cooler according to Claim 6,
wherein the bonding step is a step of bonding the metal layer (33) and the cooler (21) to each other using an Al-Si-based brazing material.

**Patentansprüche**

1. Lichtemittierendes Modul (10, 40, 50, 60) mit einem Kühler, umfassend:

eine Schaltungsschicht (32, 44), die auf einer Oberflächenseite (31a) einer Isolierschicht (31) gebildet ist, und auf der ein lichtemittierendes Halbleiterelement (11) montiert ist;
und
eine Metallschicht (33) und ein Kühler (21), die der Reihe nach auf der anderen Oberflächenseite (31b) der Isolierschicht (31) laminiert sind;
wobei die Schaltungsschicht (32, 44) aus einem gebildet ist, ausgewählt aus der Gruppe bestehend aus Kupfer, einer Kupferlegierung, Aluminium und einer Aluminiumlegierung, und eine Dicke von 0,01 mm bis 0,09 mm aufweist,
wobei die Metallschicht (33) und der Kühler (21) aus Aluminium oder einer Aluminiumlegierung gebildet sind,
wobei die Metallschicht (33) eine Dicke von 0,9 mm bis 1,6 mm aufweist,
wobei ein Verhältnis einer Fläche des lichtemittierenden Halbleiterelements (11) zu einer Fläche der einen Oberfläche (31a) der Isolierschicht (31) innerhalb eines Bereichs von 1:20 bis 1:400 ist, und
wobei die Metallschicht (33) und der Kühler (21) direkt aneinandergebunden sind.

2. Lichtemittierendes Modul (50) mit einem Kühler nach Anspruch 1, wobei ein Metallblock (55) zum Erhöhen einer Wärmekapazität des Kühlers (21) direkt an den Kühler (21) gebunden ist.

3. Lichtemittierendes Modul (60) mit einem Kühler nach Anspruch 1, wobei der Kühler (21) einen Ausnehmungsabschnitt (65) beinhaltet, in den mindestens ein Teil der Metallschicht (33) imstande ist, eingepasst zu werden.

4. Lichtemittierendes Modul (10, 50, 60) mit einem Kühler nach einem der Ansprüche 1 bis 3, wobei die Schaltungsschicht (32) und das lichtemittierende Halbleiterelement (11) über eine Ag-Schicht (19) aneinandergebunden sind.

5. Lichtemittierendes Modul (40) mit einem Kühler nach einem der Ansprüche 1 bis 3, wobei die Schaltungsschicht (44) und das lichtemittierende Halbleiterelement (11) über eine Au-Sn-Legierungsschicht (43) aneinandergebunden sind.

6. Verfahren zur Herstellung eines lichtemittierenden Moduls (10, 40, 50, 60) mit einem Kühler, eine Schaltungsschicht (32, 44) beinhaltend, die auf einer Oberflächenseite (31a) einer Isolierschicht (31) gebildet ist, und auf der ein lichtemittierendes Halbleiterelement (11) montiert ist, und eine Metallschicht (33) und einen Kühler (21), die der Reihe nach auf der anderen Oberflächenseite (31b) der Isolierschicht (31) laminiert sind, wobei die Schaltungsschicht (32, 44) aus einem Material von einem beliebigen aus Kupfer, einer Kupferlegierung, Aluminium und einer Aluminiumlegierung gebildet ist, und eine Dicke von 0,01 mm bis 0,09 mm aufweist,
wobei die Metallschicht (33) und der Kühler (21) aus Aluminium oder einer Aluminiumlegierung gebildet sind,
wobei die Metallschicht (33) eine Dicke von 0,9 mm bis 1,6 mm aufweist, und
wobei ein Verhältnis einer Fläche des lichtemittierenden Halbleiterelements (11) zu einer Fläche der einen Oberfläche (31a) der Isolierschicht (31) innerhalb eines Bereichs von 1:20 bis 1:400 ist,
wobei das Verfahren umfasst
einen Bindungsschritt des direkten Bindens der Metallschicht (33) und des Kühlers (21) aneinander.

**7.** Verfahren zur Herstellung eines lichtemittierenden Moduls (10, 40, 50, 60) mit einem Kühler nach Anspruch 6, wobei der Bindungsschritt ein Schritt des Bindens der Metallschicht (33) und des Kühlers (21) aneinander unter Verwendung eines Al-Si-basierten Lötmaterials ist.

## Revendications

**1.** Module électroluminescent (10, 40, 50, 60) ayant un refroidisseur, comprenant :

une couche de circuit (32, 44) qui est formée sur un côté de surface (31a) d'une couche isolante (31) et sur laquelle un élément électroluminescent à semi-conducteur (11) est monté ; et
une couche métallique (33) et un refroidisseur (21) qui sont stratifiés dans un ordre sur l'autre côté de surface (31b) de la couche isolante (31), dans lequel
la couche de circuit (32, 44) est formée de l'un quelconque choisi parmi le groupe comprenant du cuivre, un alliage de cuivre, de l'aluminium, et un alliage d'aluminium et présente une épaisseur de 0,01 mm à 0,09 mm, dans lequel
la couche métallique (33) et le refroidisseur (21) sont formés d'aluminium ou d'un alliage d'aluminium, dans lequel
la couche métallique (33) présente une épaisseur de 0,9 mm à 1,6 mm, dans lequel
un rapport entre une superficie de l'élément électroluminescent à semi-conducteur (11) et une superficie de la surface (31a) de la couche isolante (31) est dans une plage de 1:20 à 1:400, et dans lequel
la couche métallique (33) et le refroidisseur (21) sont directement liés l'un à l'autre.

**2.** Module électroluminescent (50) ayant un refroidisseur selon la revendication 1,
dans lequel un bloc métallique (55) pour augmenter une capacité thermique du refroidisseur (21) est directement lié au refroidisseur (21).

**3.** Module électroluminescent (60) ayant un refroidisseur selon la revendication 1,
dans lequel le refroidisseur (21) inclut une partie évidée (65) dans laquelle au moins une partie de la couche métallique (33) peut être montée.

**4.** Module électroluminescent (10, 50, 60) ayant un refroidisseur selon l'une quelconque des revendications 1 à 3,
dans lequel la couche de circuit (32) et l'élément électroluminescent à semi-conducteur (11) sont liés l'un à l'autre via une couche d'Ag (19).

**5.** Module électroluminescent (40) ayant un refroidisseur selon l'une quelconque des revendications 1 à 3,
dans lequel la couche de circuit (44) et l'élément électroluminescent à semi-conducteur (11) sont liés l'un à l'autre via une couche d'alliage Au-Sn (43).

**6.** Procédé de production d'un module électroluminescent (10, 40, 50, 60) ayant un refroidisseur incluant une couche de circuit (32, 44) qui est formée sur un côté de surface (31a) d'une couche isolante (31) et sur laquelle un élément électroluminescent à semi-conducteur (11) est monté, et une couche métallique (33) et un refroidisseur (21) qui sont stratifiés dans un ordre sur l'autre côté de surface (31b) de la couche isolante (31), dans lequel
la couche de circuit (32, 44) est formée d'un matériau de l'un quelconque parmi du cuivre, un alliage de cuivre, de l'aluminium, et un alliage d'aluminium et présente une épaisseur de 0,01 mm à 0,09 mm, dans lequel
la couche métallique (33) et le refroidisseur (21) sont formés d'aluminium ou d'un alliage d'aluminium, dans lequel
la couche métallique (33) présente une épaisseur de 0,9 mm à 1,6 mm, et dans lequel
un rapport entre une superficie de l'élément électroluminescent à semi-conducteur (11) et une superficie de la surface (31a) de la couche isolante (31) est dans une plage de 1:20 à 1:400,
le procédé comprenant
une étape de liaison consistant à lier directement la couche métallique (33) et le refroidisseur (21) l'un à l'autre.

**7.** Procédé de production d'un module électroluminescent (10, 40, 50, 60) ayant un refroidisseur selon la revendication 6,
dans lequel l'étape de liaison est une étape consistant à lier la couche métallique (33) et le refroidisseur (21) l'un à l'autre en utilisant un matériau de brasage à base d'Al-Si.

FIG. 1

FIG. 2

FIG. 3

FIG. 4

## FIG. 5

## FIG. 6

FIG. 7

(a)

(b)

(c)

**REFERENCES CITED IN THE DESCRIPTION**

**Patent documents cited in the description**

- EP 2833400 A1
- WO 2014148420 A1
- EP 2455991 A1
- JP 2015166304 A
- JP 2008240007 A
- JP 2015070199 A
- JP 2013153157 A